# EUROPEAN PATENT APPLICATION

(11) **EP 1 942 205 A2**
(43) Date of publication of application: **09.07.2008**
(21) Application number: 07108160.8
(22) Date of filing: 14.05.2007
(51) Int. Cl.: C23C 14/34, C23C 14/06

(54) **Sputtering targets and methods for fabricating sputtering targets having multiple materials**

(30) Priority: 08.01.2007 US 650515
(71) Applicant: Heraeus, Inc., Chandler AZ 85226 (US)
(72) Inventor: Zhang, Wenjun, 214011 Suzhou (CN)
(74) Representative: Hill, Justin John

(57) **Abstract**

A sputter target comprises a plurality of materials. The plurality of materials includes at least a first material and a second material. The first material is comprised of cobalt (Co), chromium (Cr), ruthenium (Ru), nickel (Ni), or iron (Fe). The second material is comprised of carbon (C), a carbon (C)-containing material, a carbide, a nitrogen (N)-containing material, a nitride, a silicon (Si)-containing material, a silicide, an oxygen (O)-containing material, an oxide, boron (B), a boron (B)-containing material or a boride. The second material constitutes a phase where the phase of the second material has an average size between greater than 0 micron and 50 microns. According to one aspect, the first material comprises at least 15 atomic percent or greater. Methods of fabricating sputter targets by blending a plurality of materials are also disclosed.

## Description

### Field of the Invention

The present invention generally relates to sputtering targets and methods for fabricating sputtering targets and, in particular, relates to sputter targets comprising a plurality of materials including at least a first material and a second material, the first material comprised of cobalt (Co), chromium (Cr), ruthenium (Ru), nickel (Ni), or iron (Fe) and the second material comprised of carbon (C), a carbon (C)-containing material, a carbide, a nitrogen (N)-containing material, a nitride, silicon (Si), a silicon (Si)-containing material, a silicide, an oxygen (O)-containing material, an oxide, boron (B), a boron (B)-containing material, or a boride, and further relates to methods for fabricating such sputter targets, and products produced thereby.

### Background of the Invention

Cathodic sputtering processes are widely used for the deposition of thin films of material onto desired substrates. A typical sputtering system includes a plasma source for generating an electron or ion beam, a target that comprises a material to be atomized and a substrate onto which the sputtered material is deposited. The process involves bombarding the target material with an electron or ion beam at an angle that causes the target material to be sputtered or eroded. The sputtered target material is deposited as a thin film or layer on the substrate.

### Summary of the Invention

According to one embodiment, the present invention relates to a novel method of fabricating sputtering targets that include non-metals such as boron, carbon, nitrogen, oxygen, silicon, a boride, a carbide, a nitride, an oxide, a silicide, a boron (B)-containing material, a carbon (C)-containing material, a nitrogen (N)-containing material, an oxygen (O)-containing material, or a silicon (Si)-containing material, including mixtures of non-metals, compounds of non-metals, master alloys containing boron, carbon or silicon and products produced by these processes. According to one embodiment, a process comprises preparation of pre-alloyed powder(s) or master alloy powder(s) or selection of ultra fine compound powder(s) of about 0.01 to 50 microns, preferably 0.1 to 10 microns, more preferably 1.0 to 5.0 microns average particle size and most preferably less than 2 microns. It has been discovered that spitting will not occur when the above phases are in form of ultra fine particles of less than 50 microns, preferably less than 10 microns in size. After the ultra fine powders are blended together, the powder blend is canned, followed by a hot isostatic press (HIP) consolidation. Powder processing as above is employed to make the target materials because of unique advantages over the prior art's melting process, both technically and economically.

According to one embodiment of the present invention, a sputter target comprises a plurality of materials. The plurality of materials includes at least a first material and a second material. The first material is comprised of cobalt (Co), chromium (Cr), ruthenium (Ru), nickel or iron (Fe). The second material is comprised of carbon (C), a carbon (C)-containing material, a carbide, a nitrogen material, a nitride, a silicon (Si)-contaming material, or a silicide. The second material constitutes a phase. The phase of the second material has an average size between greater than 0 micron and 50 microns, The first material comprises at least 15 atomic percent or greater.

According to one embodiment of the present invention, a sputter target comprises a plurality of materials. The plurality of materials includes at least a first material and a second material. The first material is comprised of cobalt (Co), ruthenium (Ru), nickel (Ni), or iron (Fe). The second material is comprised of an oxygen (O)-containing material or an oxide. The second material constitutes a phase. The phase of the second material has an average size between greater than 0 micron and 50 microns.

According to one embodiment of the present invention, a sputter target comprises a plurality of materials. The plurality of materials includes at least a first material and a second material. The first material is comprised of cobalt (Co), chromium (Cr), ruthenium (Ru), nickel (Ni), or iron (Fe). The second material is comprised of an oxygen (O)-containing material or an oxide. The second material constitutes a phase. The phase of the second material has an average size between greater than 0 micron and 50 microns. If the sputter target consists of chromium (Cr) and the oxygen (O)-containing material only, the oxygen (O)-containing material is an oxygen (O)-containing material other than simply chromium oxide. If the sputter target consists of chromium (Cr) and the oxide only, the oxide is an oxide other than simply chromium oxide.

According to one embodiment of the present invention, a sputter target comprises a plurality of materials. The plurality of materials includes at least a first material and a second material. The first material is comprised of cobalt (Co), chromium (Cr), ruthenium (Ru), nickel (Ni), or iron (Fe). The second material is comprised of boron (B), a boron (B)-containing material or a boride. The second material constitutes a phase. The phase of the second material has an average size between greater than 0 micron and less than 10 microns.

According to one embodiment of the present invention, a sputter target comprises a plurality of materials. The plurality of materials includes at least a first material and a second material. The first material is comprised of ruthenium (Ru), nickel (Ni), or iron (Fe). The second material is comprised of boron (B), a boron (B)-containing or a boride. The second material constitutes a phase. The phase of the second material has an average size between greater than 0 micron and 50 microns.

According to one aspect of the present invention, a method of fabricating a sputter target comprises the steps of: blending a plurality of materials; canning; and pressing. The plurality of materials includes at least a first material and a second material. The first material is comprised of cobalt (Co), chromium (Cr), ruthenium (Ru), nickel (Ni), or iron (Fe). The second material is comprised of carbon (C), a carbon (C)-containing material, a carbide, a nitrogen (N)-containing material, a nitride, a silicon (Si)-containing material, or a silicide. The second material has an average particle size between greater than 0 micron and 50 microns. The first material comprises at least 15 atomic percent or greater. The plurality of materials is comprised of multiple powders, one or more master alloy or compound powders, or a mixture of one or more powders with one or more master alloy or compound powders.

According to one aspect of the present invention, a method of fabricating a sputter target comprises the steps of: blending a plurality of materials; canning; and pressing. The plurality of materials includes at least a first material and a second material. The first material is comprised of cobalt (Co), ruthenium (Ru), nickel (Ni), or iron (Fe). The second material is comprised of an oxygen (O)-containing material or an oxide. The second material has an average particle size between greater than 0 micron and 50 microns. The plurality of materials is comprised of multiple powders, one or more master alloy or compound powders, or a mixture of one or more powders with one or more master alloy or compound powders.

According to one aspect of the present invention, a method of fabricating a sputter target comprises the steps of: blending a plurality of materials; canning; and pressing. The plurality of materials includes at least a first material and a second material. The first material is comprised of cobalt (Co), chromium (Cr), ruthenium (Ru), nickel (Ni), or iron (Fe). The second material is comprised of an oxygen (O)-containing material or an oxide. The second material has an average particle size between greater than 0 micron and 50 microns. The plurality of materials is comprised of multiple powders, one or more master alloy or compound powders, or a mixture of one or more powders with one or more master alloy or compound powders. If the plurality of materials consists of chromium (Cr) and the oxygen (O)-containing material only, the oxygen (O)-containing material is an oxygen (O)-coniaining material other than simply chromium oxide. If the plurality of materials consists of chromium (Cr) and the oxide only, the oxide is an oxide other than simply chromium oxide.

According to one aspect of the present invention, a method of fabricating a sputter target comprises the steps of: blending a plurality of materials; canning; and pressing. The plurality of materials includes at least a first material and a second material. The first material is comprised of cobalt (Co), chromium (Cr), ruthenium (Ru), nickel (Ni), or iron (Fe). The second material is comprised of boron (B), a boron (B)-containing material or a boride. The second material has an average particle size between greater than 0 micron and less than 10 microns. The plurality of materials is comprised of multiple powders, one or more master alloy or compound powders, or a mixture of one or more powders with one or more master alloy or compound powders.

According to one aspect of the present invention, a method of fabricating a sputter target comprises the steps of: blending a plurality of materials; canning; and pressing. The plurality of materials includes at least a first material and a second material. The first material is comprised of ruthenium (Ru), nickel (Ni), or iron (Fe). The second material is comprised of boron (B), a boron (B)-containing material or a boride. The second material has an average particle size between greater than 0 micron and less than 50 microns. The plurality of materials is comprised of multiple powders, one or more master alloy or compound powders, or a mixture of one or more powders with one or more master alloy or compound powders.

### Brief Description of the Drawings

Reference is now made to the accompanying drawing wherein:

FIG. 1 shows the process flow chart of the invention described herein according to one aspect of the present invention.

FIG. 2 illustrates a representative microstructure of a consolidated (Co₇₄Cr₁₀Pt₁₆)₉₂ - (SiO₂)₈ alloy according to one aspect of the present invention.

FIG. 3 illustrates a representative microstructure of consolidated (Co₇₄Cr₁₀Pt₁₆)₉₂ - (SiO₂)₈ alloy according to one aspect of the present invention.

Appendix 1 shows a Periodic Table of elements.

### Detailed Description of the Invention

Sputtering target materials for sputtering process range from pure metals to ever more complicated alloys. Complex 3 to 6 element alloys may be utilized for sputtering targets. Alloying additions such as boron, carbon, nitrogen, oxygen, silicon and so on are added to Cr-, Co-, Fe-based alloys to modify characteristics such as deposited film grain-size, surface energy and magnetic properties.

According to one embodiment, the presence of non-metal additions like boron, carbon, nitrogen, oxygen and silicon to target materials is either in the form of pure elements, e.g. boron and carbon, or in the form of compounds like boride, carbide, nitride and oxide. The pure element phases such as boron and carbon and the compound phases like boride, carbide, nitride, oxide, and silicide, however cause spitting problems during sputtering. The present invention provides a solution to this problem.

The powders of the present invention include elemental powders, pre-alloyed powders, powders of master alloys and/or intermetallic compound powders composed of 2 to 6 elements, including but not limited to Cr-, Co-, Ru-, Ni-, and/or Fe-based alloys. According to one aspect of the present invention, examples of master alloys include pre-alloyed powders, and pre-alloyed powders may be atomized master alloys.

The powders of the present invention contain pure Cr, Co, Ru, Ni, Fe, Pt and/or Ta and/or (optionally) pre-alloyed or master alloy powders of said pure elements, and include at least a boride, a boron (B)-containing material (e.g., boron based inorganic compound or master alloy), a carbide, a carbon (C)-containing material (e.g., carbon based inorganic compound or master alloy), a nitride, a nitrogen (N)-containing material, a silicide, a silicon (Si)-contaimng material (e.g., silicon based master alloy), an oxide, or an oxygen (O)-containing material of one or more elements from the Periodic Table of elements shown in Roman numeral column number IIA, IIIA, IV A, VA, VIA, VIIA, VIIIA, IB, IIB, IIIB or IVB (see Appendix 1). These Roman numeral column numbers correspond to column numbers 2, 3, 4, 5, 6, 7, 8, 9, 10, 11, 12, 13 and 14.

Examples of a boron (B)-containing material include a boride; examples of a carbon (C)-containing material include a carbide; examples of a nitrogen (N)-containing material include a nitride; examples of a silicon (Si)-containing material include a silicide; and examples of an oxygen (O)-containing material includes an oxide.

In preferred embodiments, the non-metallic additive is in combined form such as an inorganic compound or a master alloy of a non-metal although elemental additions may be used if desired. Preferred doping non-metals are compounds of boron, carbon and nitrogen. In still other embodiments compounds of oxygen or silica are included as dopants. Preferred doping compounds are borides or boron (B)-containing materials, carbides, or carbon (C)-containing materials and nitrides, as well as oxides and silicides or silicon (Si)-containing master alloys. Especially preferred compounds are MoB, AlN (Aluminum Nitride), and B₄C, as well as Al₂O₃, Cr₂O₃, SiO₂, and mixtures thereof. The amount of dopant may range from about 1 to 15 atomic percent (at.%), and preferably from 1 to 12 at.%.

In further embodiments, the step of forming the doped elemental powders or alloys is carried out by mechanical mixing to achieve substantially uniform blending of the materials. In further embodiments, the canning step is carried out so as to avoid segregation of the doped element or alloy.

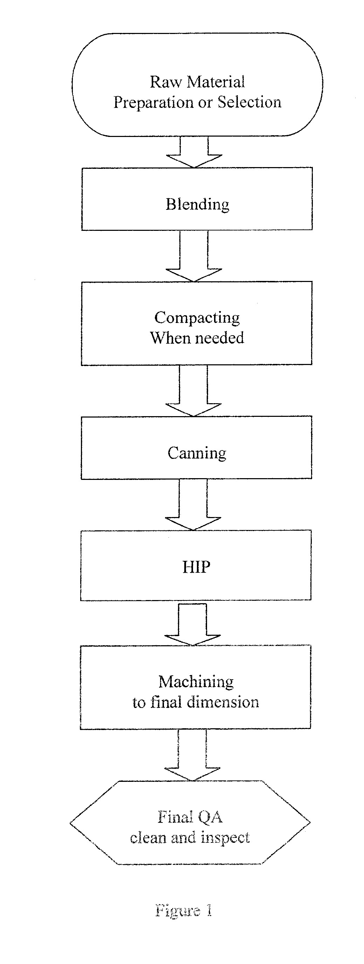

FIG. 1 shows the process flow for making the targets. The first step is the preparation of raw material powders like atomized alloy powders of Ni-Al-B, Fe-B, Fe-C, Fe-Si and so on or the selection of commercially available ultra fine compound powders such as Al₂O₃, AlN, MoB and Cr₂O₃ of 10 microns or less. Atomized powders have very fine microstructure because of extremely quick cooling and rapid solidification; therefore it is the first choice as raw materials. In some cases powders of fine microstructures can also be made by melting and mechanically crushing ingots much more economically than by atomization, especially for small quantities of powder. Some ultra fine compound powders like Al₂O₃, AlN, MoB, Cr₂O₃, B₄C and so on are also commercially available, and therefore save both time and money for new product development. Special blending methods of various powders together are required because segregation occurs quite often, especially when powders of differing particle size and gravity are combined. Those special blending and homogenizing methods include ball milling, v-blending, tubular blending, and attritor milling and/or wet blending. Therefore, it is preferred that the alloy powders and/or mixture be substantially homogeneous for best results.

Proper canning techniques are needed to avoid segregation during canning. Hot pressing in a graphite die could be used as well to consolidate the powder. The powders are canned in preparation for consolidation. In canning for example, a container is filled with the powder, evacuated under heat to ensure the removal of any moisture or trapped gasses present, and then sealed. In vacuum hot pressing, the chamber is continuously evacuated prior to and during load application. Although the geometry of the container is not limited in any manner, the container can possess a near-net shape geometry with respect to the final material configuration.

The encapsulate material from the canning step is then consolidated preferably via Hot-Isostatic-Pressing (HIP), a procedure known in the art. A HIP unit is typically a cylindrical pressure vessel large enough to house one or more containers. The inner walls of the vessel can be lined with resistance heating elements, and the pressure can be controlled by the introduction of inert gas within the container. HIP parameters including temperature, pressure and hold time will be minimized to prevent the growth of compound phases and grain size, as well as to save energy and to protect the environment. Pressures of about 5 to about 60 ksi (preferably 10-20 ksi) at temperatures between about 500°C to about 1500°C, are typically employed to achieve appropriate densities. Depending upon the complexity of the cycle, total hold times during isostatic pressing typically vary from about 0.5 to about 12 hours. Pressure during vacuum hot pressing is varied from 0.5 to 5 ksi (preferably 1.5 to 2.5 ksi) at temperatures ranging from about 500°C to 1500° C. (preferably 800-1000°C). It is noteworthy that other powder consolidation techniques such as hot pressing and cold pressing can also be employed independently or in conjunction with HIP processing.

After consolidation, the solid material form (billet) is removed from the encapsulation can, and a slice of the billet can then be sent to be tested as to various properties of the billet. If desired, the billet can be subjected to optional thermomechanical processing to further manipulate the microstructural and macro-magnetic properties of the target. Also, the final shape and size of the sputter targets can be formed, for example, by processes such as wire EDM, saw, waterjet, lathe, grinder, mill, etc. In these steps, the target can be cleaned and subjected to a final inspection.

Table 1 shows examples of sputter target materials and their exemplary chemistry in accordance with one aspect of the present invention.

**Table 1: alloys manufactured using the method described herein.**

| **Materials** | **Exemplary Chemistry** |
|---|---|
| Co-Cr-Pt-B | Co61at%-Cr15at%-Pt12at%-B12at% |
| Co-Cr-Pt-O-Si | Co56at%-Cr18at%-Pt16at%-SiO₂ (0.5-10) mol% |
| Co-Pt-B-C | Co60at%-Pt20at%-B16at%-C4at% |
| Co-Ta-N | Co50at%-Ta50at% doped with nitrogen of 1-4 at.% |
| Co-Ta-Zr-O-Si | Co85at%-Ta5at%-Zr5at%-SiO₂ (0.5-10) mol% |
| Co-Ti-Pt-B | Co62at%-Ti6at%-Pt12at%-B20at% |
| Cr-B | Cr97at%-B3at% |
| Cr-Mo-B | Cr80at%-Mo15at%-B5at% |
| Cr-Mo-O | Cr80at%-Mo20at% doped with oxygen of 1-4 at.% |
| Cr-O | Cr doped with oxygen of 1-4 at.% |
| Cr-Ti-B | Cr80at%-Ti16at%-B4at% |
| Cr-V-O | Cr80at%-V20at% doped with oxygen of 1-4 at.% |
| Cr-V-Zr-O | Cr79at%-V20at%-Zrlat% doped with oxygen of 1-4 at.% |
| Cr-W-O | Cr90at%-W10at% doped with oxygen of 1-4 at.% |
| Cr-Zr-O | Cr99at%-Zr1at% doped with oxygen of 1-4 at.% |
| Fe-Co-B | Fe56at%-Co31at%-B11at% |
| Fe | -Si-Al Fe73at%-Si17at%-Al10at% |
| Fe-Ta-C | Fe80at%-Ta8at%-C12at% |
| Ni-Al-B | Ni50at%-Al50at% doped with boron of 1-4 at.% |
| Ni-Al-N | Ni48at%-Al48at% doped with nitrogen of 4 at% |
| Ni-Al-O | Ni50at%-Al50at% doped with oxygen of 1-4 at.% |
| Ru-Al-O | Ru50at%-Al50at% doped with oxygen of 1-4 at.% |
| Ru-Al-N | Ru50ac%-Al50at% doped with nitrogen of 1-4 at.% |

Table 2 shows examples of sputter target materials and their exemplary phases in accordance with one aspect of the present invention. The sputter target materials set forth in each row may include some or all of the exemplary phases described in the row, and they may include other additional phases.

**Table 2: alloys manufactured using the method described herein.**

| **Materials** | **Exemplary Phases** |
|---|---|
| Co-Cr-Pt-B | Co-Cr master alloy; Co-Cr-B master alloy; Pt; Co; Cr; Co-B master alloy; Co-B compound; Cr-B master alloy; Cr-B compound; Co-Pt master alloy |
| Co-Cr-Pt-O-Si | Co; Co-Cr master alloy; Pt; SiO₂; Co-Cr-Pt master alloy |
| Co-Ta-Zr-O-Si | Co-Zr master alloy; Co-Ta master alloy; ZrO₂; SiO₂; Co; CoSi₂; Co-Ta-Zr master alloy |
| Co-Ti-Pt-B | Co-B master alloy; Co-Ti master alloy; Co-Pt master alloy; Ti-B compound |
| Cr-Ti-B | Cr; Ti; Cr-B master alloy; Cr₂B compound; TiB₂ compound |
| Fe-Ta-C | Fe; C; Ta-C compound |
| Fe-Ta-C | Fe; Fe-C master alloy; Ta-C compound |
| Ni-Al-B | Ni; Ni-Al compound (e.g., NiAl, NiAl₃); Ni-Ai master alloy; Ni-B master alloy; Ni-B compound (e.g., Ni₃B); AlB₂ compound |
| Ru-Al-O | Ru; Al; aluminum oxide; ruthenium oxide; Ru-Al compound (e.g., Al₆Ru, Al₁₃Ru₄, Al₂Ru, AlRu) |

Table 3 shows examples of sputter target materials and their exemplary powders that may be used to fabricate the sputter targets. The sputter target materials set forth in each row may be fabricated using some of all of the powders set forth in the row and optionally using other additional powders.

**Table 3: alloys manufactured using the method described herein.**

| **Materials** | **Exemplary Powders** |
|---|---|
| Co-Cr-Pt-O-Si | Cr powder, Co-Cr master alloy powder, Pt powder; SiO₂ compound powder |
| Cr-Mo-B | Cr powder; Mo powder; B powder |
| Cr-Ti-B | Cr powder; Ti powder; B powder |
| Fe-Si-Al | Fe-Si master alloy powder; Fe-Al master alloy powder; Fe-Si silicide |

### EXAMPLES

The following examples demonstrate the present invention further, but should not be construed as a limitation of the present invention. The processes for all materials are similar with each other as shown in Figure 1, and the main differences are various combinations of raw materials (powders).

Example 1: Production Of Cr-Mo Based Sputtering Target With Boron Content - Cr80at%-Mo 15at%-B5at%

The above alloy is made with the following powder blends: (1) Cr powder, Mo powder and ultra fine MoB compound powder, or (2) Cr powder, Mo powder and pre-alloyed Cr-3.1wt%B powder (i.e., Cr-3.1wt%B master alloy powder) that is made with a vacuum induction melter at 1730 °C and mechanically crushing cast ingots into powder at room temperature. The pre-alloyed Cr-3.1wt.%B powder can also be made by gas atomization. Special attention must be paid to mixing all powders together when ultra fine compound powder like MoB is used, otherwise segregation may occur. Herewith an attritor mill or a ball mill must be used for blending from 2 to 24 hours. The HIP parameters for this kind of alloy include the temperature ranging from about 1000 - 1400 °C, at a pressure from about 5 - 40 ksi and a hold time from about 1 - 12 hours. The cooling rate must be controlled too, otherwise the HIPed billet may crack during cooling down. A cooling rate of 3 °C/min and a hold plateau at 800 °C for 6 hours is introduced to cooling phase.

Example 2: Production Of Co-Cr-Pt Based Sputtering Target With SiO₂ Content - Co56at%-Cr18at%-Pt16at%-O3.33at%-Si1.67at%

Two different combinations of starting powders are employed herein. A first alternative is the combination of Co powder, Cr powder, Pt powder and ultra fine SiO₂ compound powder. A second alternative is the combination of Co powder, Cr powder, Pt powder, atomized Co-Si pre-alloy powder (i.e., Co-Si master alloy powder) and ultra fine Cr₂O₃ compound powder. The silicides are ultra fine and well dispersed in Co matrix of original gas-atomized Co-Si particles. Special mixing methods using an attritor mill or a ball mill for 2 to 24 hours must be employed here to mix all powders together homogeneously when ultra fine compound powders like SiO₂ and Cr₂O₃ are used, otherwise segregation may occur. The HIP parameters for this kind of alloy include the temperature ranging from about 600 - 1400 °C, at a pressure from about 5 - 40 ksi and a hold time from about 1 - 12 hours.

Example 3: Production Of Cr-Mo-X (wherein X is boride, carbide, nitride or oxide, or mixtures thereof) Sputtering Target. To produce Cr-Mo-X, Cr powder, Mo powder, and one or both of Cr oxide powder and Mo oxide powder are utilized according to one aspect of the present invention.

One example of Cr-Mo-X: Cr80at%-Mo20at% doped with oxygen of 1-4 atomic % (at.%).

Regular Cr powder, Mo powder and partly oxidized Cr compound powder of oxygen level 15000 ppm are used to make the targets. The Cr powder of high oxygen is produced by oxidizing Cr flakes at high temperature and then subjected to mechanical crushing. In this case, only a part of the surface area of Cr powder is covered with oxides. Special attention must be paid to Cr powder of high oxygen level and mixing all powders together in this case, otherwise segregation may occur. Herewith an attritor mill or a ball mill may be used for blending from 2 to 24 hours. The HIP parameters for this kind of alloy include the temperature ranging from about 800 - 1400 °C, at a pressure from about 5 - 40 ksi and a hold time from about 1 - 12 hours. The cooling rate must be controlled too, otherwise the HIPed billet may crack during cooling down. A cooling rate of 3 °C/min and a hold plateau at 800 °C for 6 hours is introduced to cooling phase.

Example 4: production of NiAl sputtering target doped with boron, oxygen or nitrogen - Ni50at%-A150at% doped with boron of 1-4 at.%.

Gas-atomized NiAl intermetallic compound powder and ultra fine Al₂O₃ compound powder and AlN compound powder of less than 5 microns in average particle diameter size were taken for making NiAl sputtering targets doped with oxygen or nitrogen. Besides gas-atomized NiAl powder, boron-doped gas-atomized NiAl powder was also taken for making NiAl sputtering targets doped with boron and borides are ultra fine and well dispersed in the matrix. Conventional gas atomization methods are used to manufacture the powders. Special attention must be paid to mixing all powders together when ultra fine compound powders like Al₂O₃ and AlN are used, otherwise segregation may occur. Herewith an attritor mill or a ball mill may be used for blending from 2 to 24 hours. The HIP parameters for this kind of alloy include the temperature ranging from about 900 - 1400 °C, at a pressure from about 5 - 40 ksi, and a hold time from about 1 12 hours. The cooling rate must be controlled too, otherwise the HIPed billet may crack during cooling down. A power-off furnace cooling and a hold plateau at 700 °C for 4 hours is introduced to cooling phase.

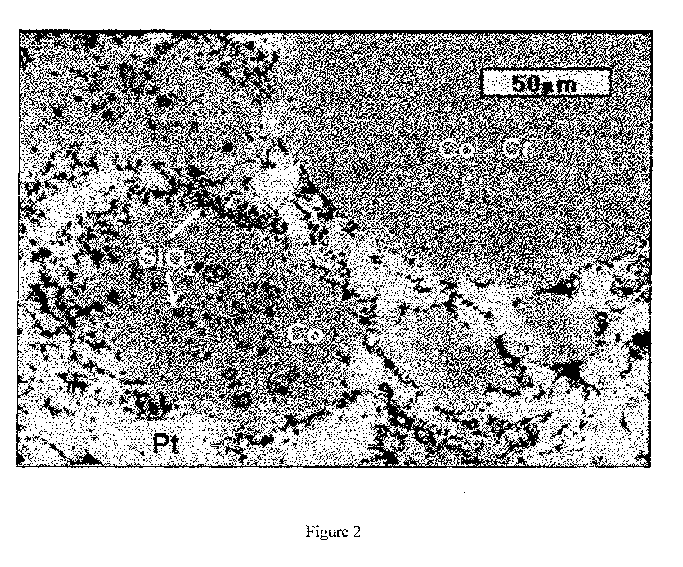

Figure 2 illustrates a representative microstructure of a Co-Cr-Pt-O-Si sputter target according to one aspect. The sputter target is manufactured using 100-mesh cobalt (Co) powder at 29.53 wt. %, 100-mesh Co-24.22Cr powder at 27.73 wt. %, >0µm and <5µm SiO₂ powder at 6.13 wt. %, and platinum (Pt) powder at 36.61 wt. %. The manufactured sputter target includes, for example, a first material, a second material and a third material. The first material is comprised of Co (e.g., Co-Cr master alloy or Co). The second material is comprised of an oxide, or more specifically SiO₂ compound in this example. The third material is comprised of Pt. The first material may constitute a first phase, the second material may constitute a second phase, and the third material may constitute a third phase. The second phase of the second material has an average size between greater than 0 and 50 microns.

The sputter target includes dark Co phases, dark Co-Cr master alloy phases, light Pt phases, and dark SiO₂ compound phases. In this example, the SiO₂ compound phases have an average size between greater than 0 and 10 microns (e.g., between greater than 0 and 5 microns).

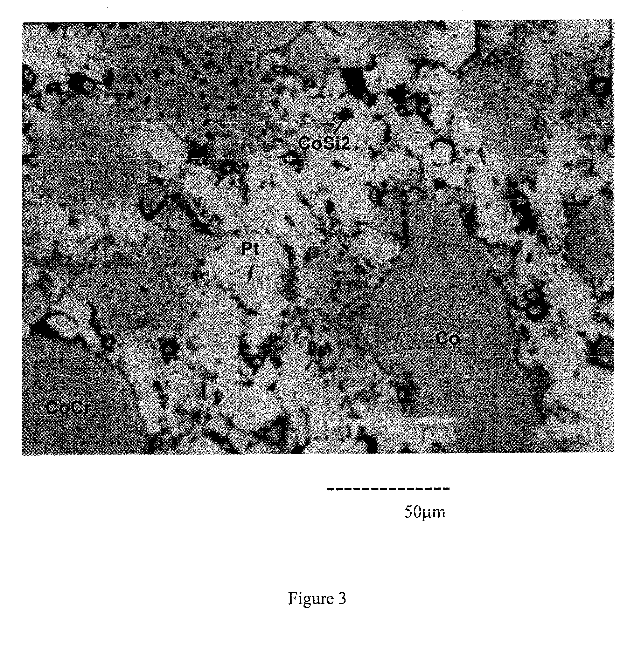

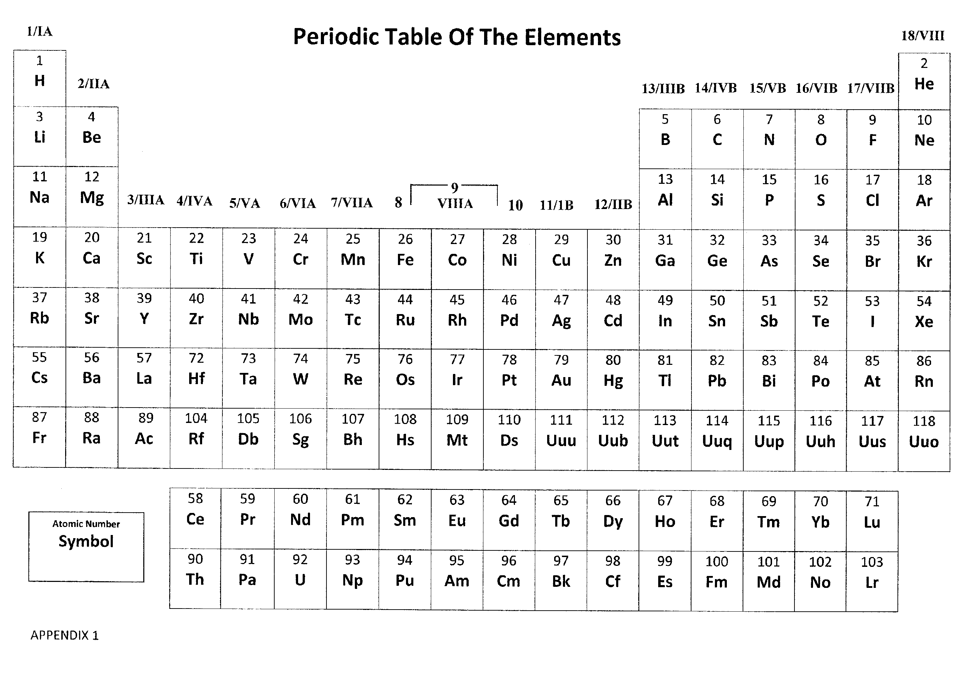

Figure 3 illustrates a representative microstructure of a Co-Cr-Pt-O-Si sputter target according to one aspect. The sputter target is manufactured using 16.97 wt. % cobalt (Co) powder, 5.49 wt. % CoSi₂ powder, 14.52 wt. % CoO powder, 26.4 wt. % Co-24.22Cr powder, and 36.62 wt. % platinum (Pt) powder. The manufactured sputter target includes, for example, a first material, a second material and a third material. The first material is comprised of Co (e.g., Co-Cr master alloy or Co). The second material is comprised of a silicide, or more specifically CoSi₂ compound. The third material is comprised of Pt. The first material may constitute a first phase, the second material may constitute a second phase, and the third material may constitute a third phase. The second phase of the second material has an average size between greater than 0 and 50 microns.

The sputter target includes dark Co phases, dark Co-Cr master alloy phases, light Pt phases, and dark CoSi₂ compound phases. In this example, the CoSi₂ compound phases have an average size between greater than 0 and 5 microns. The Co phases have an average size between greater than 0 and 150 microns.

According to one embodiment of the present invention, a sputter target comprises a plurality of materials. The plurality of materials includes at least a first material and a second material. The first material is comprised of cobalt (Co), chromium (Cr), ruthenium (Ru), nickel (Ni), or iron (Fe). For example, the first material is comprised of one or more of the following according to one aspect: a cobalt (Co) element, a chromium (Cr) element, a ruthenium (Ru) element, a nickel (Ni) element, an iron (Fe) element, a cobalt (Co) based master alloy, a chromium (Cr) based master alloy, a ruthenium (Ru) based master alloy, a nickel (Ni) based master alloy, an iron (Fe) based master alloy, a cobalt (Co) based compound, a chromium (Cr) based compound, a ruthenium (Ru) based compound, a nickel (Ni) based compound, and an iron (Fe) based compound. According to one aspect, the first material comprises at least 15 atomic percent or greater. According to one aspect, the first material constitutes a first phase, and the first phase has an average size between greater than 0 micron and 50 microns (i.e., 0 < phase size ≤ 50 microns). The present invention is not limited to these ranges, and in another embodiment, the first phase has an average size greater than 50 microns.

The second material is comprised of carbon (C), a carbon (C)-containing material, a carbide, a nitrogen (N)-containing material, a nitride, a silicon (Si)-containing material, a silicide, an oxygen (O)-containing material, an oxide, boron (B), a boron (B)-containing material, or a boride. For example, the second material is comprised of one or more of the following according to one aspect: MoB compound, Co-Cr-B master alloy, Co-B master alloy, Co-B compound, Cr-B master alloy, Cr-B compound (e.g., Cr₂B), Ti-B compound (e.g., TiB₂), Ti-O compound, Ni-B master alloy, Ni-B compound, Al-B compound (e.g., AlB₂), Co-Si master alloy, Fe-Si master alloy, Cr-Si compound, silicon oxide compound (e.g., SiO₂), Co-Si compound (e.g., CoSi₂, Co₂Si), titanium oxide (e.g., TiO₂), chromium oxide (e.g., Cr₂O₃), molybdenum oxide, aluminum oxide (e.g., Al₂O₃), ruthenium oxide, C (e.g., graphite), Ta-C compound, Fe-C master alloy, Fe-C compound, aluminum nitride, cobalt nitride, chromium nitride, and iron nitride.

According to one aspect, the second material constitutes a second phase, and the second phase of the second material has an average size between greater than 0 micron and 50 microns (e.g., between greater than 0 micron and 20 microns, between greater than 0 micron and 10 microns, between 0. microns and 10 microns, between greater than 0 micron and 5 microns, between 1 micron and 5 microns, between greater than 0 micron and 2 microns, or less than 2 microns, etc.).

According to one aspect, the plurality of materials further includes a third material. According to one aspect, the third material is comprised of one or more of the following: a transition element, a refractory element, a cobalt-transition element based master alloy, a cobalt-refractory element based master alloy, a transition element based compound, and a refractory element based compound. In another aspect, the third material, is comprised of platinum (Pt) or tantalum (Ta). According to one aspect, the third material constitutes a third phase, and the third phase has an average size between greater than 0 micron and 50 microns (i.e., 0 < phase size ≤ 50 microns). The present invention is not limited to these ranges, and in another embodiment, the third phase has an average size greater than 50 microns.

According to one aspect of the present invention, a sputter target is fabricated by blending a plurality of materials, canning and pressing. The plurality of materials includes at least the first material and the second material described above. The plurality of materials may also include the third material described above. The plurality of materials may further include other materials. When the plurality of materials are blended, each of the plurality of materials (e.g., each of the first, second and third materials) is in powder form, for example, elemental powders, one or more master alloy or compound powders, or a mixture of one or more powders with one or more master alloy or compound powders. Each of the first material, second material and third materials described above is in powder form for blending. According to one aspect, the particle size of the first material, the particle size of the second material, and particle size of the third material are the same as the size of the first phase, the size of the second phase, and the size of the third phase described above, respectively.

Some examples of a transition element include elements from the Periodic Table of elements shown in Roman numeral column number IIIA, IVA, VA, VIA, VIIA, VIIIA, IB, IIB according to one aspect of the present invention. Some examples of a refractory element include elements from the Periodic Table of elements shown in Roman numeral column number IIIA, IVA, VA, VIA, VIIA, VIIIA, IB, IIB that have a melting point greater than or about equal to the melting point of iron (Fe) according to one aspect of the present invention.

Some examples of a cobalt-transition element based master alloy include a Co-Cr master alloy, a Co-Mn master alloy, a Co-Fe master alloy, a Co-Cr-B master alloy, and a Co-Ni master alloy according to one aspect of the present invention. Some examples of a cobalt-refractory element based master alloy include a Co-Ta master alloy, a Co-Pt master alloy and a Co-Zr master alloy according to one aspect of the present invention.

Some examples of a transition element based compound include CoSi₂, CrSi₂, Fe₃C, and Ni₃Al according to one aspect of the present invention. Some examples of a refractory element based compound include TaC, Ta₂C, TaB₂, TaB, Mo₂C, MoSi₂, Mo₂B and Mo₂C according to one aspect of the present invention.

According to one aspect of the present invention, a master alloy is a combination of two or more elements consisting of a single or a multi-phase material, either as a simple solid solution (single-phase) of a minor element in a matrix of the major element or a combination of a solid solution and one or more secondary phases (multi-phase) having at least two constituents among the alloying elements. Compounds of two or three different elements are substances containing a defined number of each atom species and having specific physical and chemical properties, on the whole, different from those which their constituents had as elementary substances.

According to one aspect of the present invention, a sputter target includes chromium and an oxide that is not a simple chromium oxide or Cr₂O₃. For example, such sputter target includes: chromium; chromium oxide or Cr₂O₃; and other element(s), alloy(s) and/or compound(s). In another example, such sputter target includes: chromium; and a compound(s) based on a chromium oxide (as opposed to a particular chromium oxide such as Cr₂O₃).

According to one aspect of the present invention, a sputter target includes chromium and an oxide that is not a simple silicon dioxide (SiO₂). For example, such sputter target includes: chromium; silicon dioxide; and other element(s), alloy(s) and/or compound(s). In another example, such sputter target includes: chromium; and a compound(s) based on a silicon oxide (as opposed to a particular silicon oxide such as SiO₂).

While this invention has been described with reference to several preferred embodiments, it is contemplated that various alterations and modifications thereof will become apparent to those skilled in the art upon a reading of the detailed description contained herein. It is therefore intended that the following claims are interpreted as including all such alterations and modifications as fall within the true spirit and scope of this invention.

## Claims

1. A sputter target comprising a plurality of materials, the plurality of materials including at least a first material and a second material, the first material comprised of cobalt (Co), chromium (Cr), ruthenium (Ru), nickel (Ni), or iron (Fe), the second material comprised of carbon (C), a carbon (C)-containing material, a carbide, a nitrogen (N)-containing material, a nitride, a silicon (Si)-containing material, or a silicide, the second material constituting a phase, the phase of the second material having an average size between greater than 0 micron and 50 microns, the first material comprising at least 15 atomic percent or greater.

2. The sputter target of Claim 1, wherein the carbide is a carbide of one or more elements from the Periodic Table of elements shown in Roman numeral column number IIA, IIIA, IVA, VA, VIA, VIIA, VIIIA, IB, IIB, IIIB or IVB, and
wherein the nitride is a nitride of one or more elements from the Periodic Table of elements shown in Roman numeral column number IIA, IIIA, IVA, VA, VIA, VIIA, VIIIA, IB, IIB, IIIB or IVB.

3. The sputter target of Claim 1, wherein the nitrogen (N)-containing material is a nitrogen (N)-containing material including one or more elements from the Periodic Table of elements shown in Roman numeral column number IIA, IIIA, IVA, VA, VIA, VIIA, VIIIA, IB, IIB, IIIB or IVB,
wherein the carbon (C)-containing material is a carbon (C)-containing material including one or more elements from the Periodic Table of elements shown in Roman numeral column number IIA, IIIA, IVA, VA, VIA, VIIA, VIIIA, IB, IIB, IIIB or IVB,
wherein the silicon (Si)-containing material is a silicon (Si)-containing material including one or more elements from the Periodic Table of elements shown in Roman numeral column number IIA, IIIA, IVA, VA, VIA, VIIA, VIIIA, IB, IIB, IIIB or IVB, and
wherein the silicide is a silicide of one or more elements from the Periodic Table of elements shown in Roman numeral column number IIA, IIIA, IVA, VA, VIA, VIIA, VIIIA, IB, IIB, IIIB or IVB.

4. The sputter target of Claim 1, wherein the second material is comprised of the carbide or the nitride,
wherein the carbide is a carbide of one or more elements from the Periodic Table of elements shown in Roman numeral column number IIA, IIIA, IVA, VA, VIA, VIIA, VIIIA, IB, IIB, IIIB or IVB, and
wherein the nitride is a nitride of one or more elements from the Periodic Table of elements shown in Roman numeral column number IIA, IIIA, IVA, VA, VIA, VIIA, VIIIA, IB, IIB, IIIB or IVB.

5. The sputter target of Claim 1, wherein the second material is comprised of the silicide,
wherein the silicide is a silicide of one or more elements from the Periodic Table of elements shown in Roman numeral column number IIA, III A, IVA, VA, VIA, VIIA, VIIIA, IB, IIB, IIIB or IVB.

6. The sputter target of Claim 1, wherein the second material is comprised of the nitride, wherein the nitride is a nitride of aluminum (Al).

7. The sputter target of Claim 1, wherein the phase of the second material has an average size between 0.1 microns and 10 microns.

8. The sputter target of Claim 1, wherein the phase of the second material has an average size between 1 micron and 5 microns.

9. The sputter target of Claim 1, wherein the phase of the second material has an average size less than 2 microns.

10. The sputter target of Claim 1, wherein the first material is comprised of a cobalt (Co) element, a chromium (Cr) element, a ruthenium (Ru) element, a nickel (Ni) element, an iron (Fe) element, a cobalt (Co) based master alloy, a chromium (Cr) based master alloy, a ruthenium (Ru) based master alloy, a nickel (Ni) based master alloy, an iron (Fe) based master alloy, a cobalt (Co) based compound, a chromium (Cr) based compound, a ruthenium (Ru) based compound, a nickel (Ni) based compound, or an iron (Fe) based compound.

11. The sputter target of Claim 1, wherein the first material constitutes a first phase, and the first phase of the first material has an average size between greater than 0 micron and 50 microns.

12. The sputter target of Claim 1, wherein the plurality of materials includes a third material, the third material comprised of platinum (Pt) or tantalum (Ta).

13. The sputter target of Claim 1, wherein the plurality of materials further includes a third material comprised of a transition element a refractory element a cobalt-transition element based master alloy, a cobalt-refractory element based master alloy, a transition element based compound, or a refractory element based compound.

14. The sputter target of Claim 13, wherein the third material constitutes a phase, and the phase of the third material has an average size between greater than 0 micron and 50 microns.

15. The sputter target of Claim 1, wherein the sputter target comprises an alloy, the alloy including a plurality of phases, the plurality of phases including at least a first phase and a second phase, the first material constituting the first phase, the second phase being the phase of the second material, the first material comprised of a cobalt (Co) element, a chromium (Cr) element, a ruthenium (Ru) element, a nickel (Ni) element, an iron (Fe) element, a cobalt (Co) based master alloy, a chromium (Cr) based master alloy, a ruthenium (Ru) based master alloy, a nickel (Ni) based master alloy, an iron (Fe) based master alloy, a cobalt (Co) based compound, a chromium (Cr) based compound, a ruthenium (Ru) based compound, a nickel (Ni) based compound, or an iron (Fe) based compound.

16. A sputter target comprising a plurality of materials, the plurality of materials including at least a first material and a second material, the first material comprised of cobalt (Co), ruthenium (Ru), nickel (Ni), or iron (Fe), the second material comprised of an oxygen (O)-containing material or an oxide, the second material constituting a phase, the phase of the second material having an average size between greater than 0 micron and 50 microns.

17. The sputter target of Claim 16, wherein the oxide is an oxide of one or more elements from the Periodic Table of elements shown in Roman numeral column number IIA, IIIA, IVA, VA, VIA, VIIA, VIIIA, IB, IIB, IIIB or IVB.

18. The sputter target of Claim 16, wherein the oxygen (O)-containing material is an oxygen (O)-containing material including one or more elements from the Periodic Table of elements shown in Roman numeral column number IIA, IIIA, IVA, VA, VIA, VIIA, VIIIA, IB, IIB, IIIB or IVB.

19. The sputter target of Claim 16, wherein the oxide is an oxide of one or more of transition or refractory elements.

20. The sputter target of Claim 16, wherein the oxygen (O)-containing material is an oxygen (O)-containing material including one or more of transition or refractory elements.

21. The sputter target of Claim 16, wherein the second material is comprised of the oxide, wherein the oxide is an oxide of silicon (Si), aluminum (Al) or titanium (Ti).

22. The sputter target of Claim 16, wherein the second material is comprised of the oxide, wherein the oxide is silicon dioxide (SiO₂).

23. The sputter target of Claim 16, wherein the second material is comprised of the oxide, wherein the oxide is titanium oxide (TiO₂).

24. The sputter target of Claim 16, wherein the phase of the second material has an average size between 0.1 microns and 10 microns.

25. The sputter target of Claim 16, wherein the phase of the second material has an average size between 1 micron and 5 microns.

26. The sputter target of Claim 16, wherein the phase of the second material has an average size less than 2 microns.

27. The sputter target of Claim 16, wherein the first material is comprised of a cobalt (Co) element, a ruthenium (Ru) element, a nickel (Ni) element, an iron (Fe) element, a cobalt (Co) based master alloy, a ruthenium (Ru) based master alloy, a nickel (Ni) based master alloy, an iron (Fe) based master alloy, a cobalt (Co) based compound, a ruthenium (Ru) based compound, a nickel (Ni) based compound, or an iron (Fe) based compound.

28. The sputter target of Claim 16, wherein the first material constitutes a first phase, and the first phase of the first material has an average size between greater than 0 micron and 50 microns.

29. The sputter target of Claim 16, wherein the plurality of materials includes a third material, the third material comprised of platinum (Pt) or tantalum (Ta).

30. The sputter target of Claim 16, wherein the plurality of materials further includes a third material comprised of a transition element, a refractory element, a cobalt-transition element based master alloy, a cobalt-refractory element based master alloy, a transition element based compound, or a refractory element based compound.

31. The sputter target of Claim 30, wherein the third material constitutes a phase, and the phase of the third material has an average size between greater than 0 micron and 50 microns.

32. The sputter target of Claim 16, wherein the sputter target comprises an alloy, the alloy including a plurality of phases, the plurality of phases including at least a first phase and a second phase, the first material constituting the first phase, the second phase being the phase of the second material, the first material comprised of a cobalt (Co) element, a ruthenium (Ru) element, a nickel (Ni) element, an iron (Fe) element, a cobalt (Co) based master alloy, a ruthenium (Ru) based master alloy, a nickel (Ni) based master alloy, an iron (Fe) based master alloy, a cobalt (Co) based compound, a ruthenium (Ru) based compound, a nickel (Ni) based compound, or an iron (Fe) based compound.

33. The sputter target of Claim 16, wherein the sputter target is comprised of Co, Cr, Pt and SiO₂.

34. The sputter target of Claim 16, wherein the first material comprises at least 15 atomic percent or greater.

35. A sputter target comprising a plurality of materials, the plurality of materials including at least a first material and a second material, the first material comprised of cobalt (Co), chromium (Cr), ruthenium (Ru), nickel (Ni), or iron (Fe), the second material comprised of an oxygen (O)-containing material or an oxide, the second material constituting a phase, the phase of the second material having an average size between greater than 0 micron and 50 microns,
wherein if the sputter target consists of chromium (Cr) and the oxygen (O)-containing material only, the oxygen (O)-containing material is an oxygen (O)-containing material other than simply chromium oxide, and
wherein if the sputter target consists of chromium (Cr) and the oxide only, the oxide is an oxide other than simply chromium oxide.

36. The sputter target of Claim 35, wherein the oxygen (O)-containing material is an oxygen (O)-containing material including one or more elements from the Periodic Table of elements shown in Roman numeral column number IIA, IIIA, IVA, VA, VIA, VIIA, VIIIA, IB, IIB, IIIB or IVB, and
wherein the oxide is an oxide of one or more elements from the Periodic Table of elements shown in Roman numeral column number IIA, IIIA, IVA, VA, VIA, VIIA, VIIIA, IB, IIB, IIIB or IVB.

37. The sputter target of Claim 35, wherein the oxide is an oxide of one or more of transition or refractory elements, and wherein the oxygen (O)-containing material is an oxygen (O)-containing material including one or more of transition or refractory elements.

38. The sputter target of Claim 35, wherein the second material is comprised of the oxide, wherein the oxide is an oxide of silicon (Si), aluminum (Al) or titanium (Ti).

39. The sputter target of Claim 35, wherein the second material is comprised of the oxide, wherein the oxide is silicon dioxide (SiO₂).

40. The sputter target of Claim 35, wherein the second material is comprised of the oxide, wherein the oxide is titanium oxide (TiO₂).

41. The sputter target of Claim 35, wherein the phase of the second material has an average size between 0.1 microns and 10 microns.

42. The sputter target of Claim 35, wherein the phase of the second material has an average size between 1 micron and 5 microns.

43. The sputter target of Claim 35, wherein the phase of the second material has an average size less than 2 microns.

44. The sputter target of Claim 35, wherein the first material is comprised of a cobalt (Co) element, a chromium (Cr) element, a ruthenium (Ru) element, a nickel (Ni) element, an iron (Fe) element, a cobalt (Co) based master alloy, a chromium (Cr) based master alloy, a ruthenium (Ru) based master alloy, a nickel (Ni) based master alloy, an iron (Fe) based master alloy, a cobalt (Co) based compound, a chromium (Cr) based compound, a ruthenium (Ru) based compound, a nickel (Ni) based compound, or an iron (Fe) based compound,
wherein the first material constitutes a first phase, and the first phase of the first material has an average size between greater than 0 micron and 50 microns.

45. The sputter target of Claim 35, wherein the plurality of materials includes a third material, the third material comprised of platinum (Pt) or tantalum (Ta).

46. The sputter target of Claim 35, wherein the plurality of materials further includes a third material comprised of a transition element, a refractory element, a cobalt-transition element based master alloy, a cobalt-refractory element based master alloy, a transition element based compound, or a refractory element based compound.

47. The sputter target of Claim 46, wherein the third material constitutes a phase, and the phase of the third material has an average size between greater than 0 micron and 50 microns.

48. The sputter target of Claim 35, wherein the sputter target comprises an alloy, the alloy including a plurality of phases, the plurality of phases including at least a first phase and a second phase, the first material constituting the first phase, the second phase being the phase of the second material, the first material comprised of a cobalt (Co) element, a ruthenium (Ru) element, a nickel (Ni) element, an iron (Fe) element, a cobalt (Co) based master alloy, a ruthenium (Ru) based master alloy, a nickel (Ni) based master alloy, an iron (Fe) based master alloy, a cobalt (Co) based compound, a ruthenium (Ru) based compound, a nickel (Ni) based compound, or an iron (Fe) based compound.

49. The sputter target of Claim 35, wherein the sputter target is comprised of Co, Cr, Pt and SiO₂.

50. The sputter target of Claim 35, wherein the first material comprises at least 15 atomic percent or greater.

51. The sputter target of Claim 35, wherein if the sputter target consists of chromium (Cr) and the oxygen (O)-containing material only, the oxygen (O)-containing material is an oxygen (O)-containing material other than simply chromium oxide or simply silicon dioxide (SiO₂), and
wherein if the sputter target consists of chromium (Cr) and the oxide only, the oxide is an oxide other than simply chromium oxide or simply silicon dioxide (SiO₂).

52. A sputter target comprising a plurality of materials, the plurality of materials including at least a first material and a second material, the first material comprised of cobalt (Co), chromium (Cr), ruthenium (Ru), nickel (Ni), or iron (Fe), the second material comprised of boron (B), a boron (B)-containing material or a boride, the second material constituting a phase, the phase of the second material having an average size between greater than 0 micron and less than 10 microns.

53. The sputter target of Claim 52, wherein the boron (B)-containing material is a boron (B)-containing material including one or more elements from the Periodic Table of elements shown in Roman numeral column number IIA, IIIA, IVA, VA, VIA, VIIA, VIIIA, IB, IIB, IIIB or IVB, and
wherein the boride is a boride of one or more elements from the Periodic Table of elements shown in Roman numeral column number IIA, IIIA, IVA, VA, VIA, VIIA, VIIIA, IB, IIB, IIIB or IVB.

54. The sputter target of Claim 52, wherein the second material is comprised of boron (B).

55. The sputter target of Claim 52, wherein the phase of the second material has an average size less than 2 microns.

56. The sputter target of Claim 52, wherein the plurality of materials further includes a third material comprised of a transition element, a refractory element, a cobalt-transition element based master alloy, a cobalt-refractory element based master alloy, a transition element based compound, or a refractory element based compound.

57. A sputter target comprising a plurality of materials, the plurality of materials including at least a first material and a second material, the first material comprised of ruthenium (Ru), nickel (Ni), or iron (Fe), the second material comprised of boron (B), a boron (B)-containing material or a boride, the second material constituting a phase, the phase of the second material having an average size between greater than 0 micron and 50 microns.

58. The sputter target of Claim 57, wherein the boron (B)-containing material is a boron (B)-containing material including one or more elements from the Periodic Table of elements shown in Roman numeral column number IIA, IIIA, IVA, VA, VIA, VIIA, VIIIA, IB, IIB, IIIB or IVB, and
wherein the boride is a boride of one or more elements from the Periodic Table of elements shown in Roman numeral column number IIA, IIIA, IVA, VA, VIA, VIIA, VIIIA, IB, IIB, IIIB or IVB.

59. The sputter target Claim 57, wherein the plurality of materials further includes a third material comprised of a transition element, a refractory element, a cobalt-transition element based master alloy, a cobalt-refractory element based master alloy, a transition element based compound, or a refractory element based compound.

60. A method of fabricating a sputter target, the method comprising the steps of:
blending a plurality of materials including at least a first material and a second material, the first material comprised of cobalt (Co), chromium (Cr), ruthenium (Ru), nickel (Ni), or iron (Fe), the second material comprised of carbon (C), a carbon (C)-containing material, a carbide, a nitrogen (N)-containing material, a nitride, a silicon (Si)-containing material, or a silicide, the second material having an average particle size between greater than 0 micron and 50 microns, the first material comprising at least 15 atomic percent or greater, the plurality of materials comprised of multiple powders, one or more master alloy or compound powders, or a mixture of one or more powders with one or more master alloy or compound powders;
canning; and
pressing.

61. The method of Claim 60, wherein the carbon (C)-containing material is a carbon (C)-containing material including one or more elements from the Periodic Table of elements shown in Roman numeral column number IIA, IIIA, IVA, VA, VIA, VIIA, VIIIA, IB, IIB, IIIB or IVB,
wherein the carbide is a carbide of one or more elements from the Periodic Table of elements shown in Roman numeral column number IIA, IIIA, IVA, VA, VIA, VIIA, VIIIA, IB, IIB, IIIB or IVB,
wherein the nitrogen (N)-containing material is a nitrogen (N)-containing material including one or more elements from the Periodic Table of elements shown in Roman numeral column number IIA, IIIA, IVA. VA, VIA, VIIA, VIIIA, IB, IIB, IIIB or IVB,
wherein the nitride is a nitride of one or more elements from the Periodic Table of elements shown in Roman numeral column number IIA, IIIA, IVA, VA, VIA, VIIA, VIIIA, IB, IIB, IIIB or IVB,
wherein the silicon (Si)-containing material is a silicon (Si)-containing material including one or more elements from the Periodic Table of elements shown in Roman numeral column number IIA, IIIA, IVA, VA, VIA, VIIA, VIIIA, IB, IIB, IIIB or IVB, and
wherein the silicide is a silicide of one or more elements from the Periodic Table of elements shown in Roman numeral column number IIA, IIIA, IVA, VA, VIA, VIIA, VIIIA, IB, IIB, IIIB or IVB.

62. The method of Claim 60, wherein the second material is comprised of the carbide, the nitride, or the silicide,
wherein the carbide is a carbide of one or more elements from the Periodic Table of elements shown in Roman numeral column number IIA, IIIA, IVA, VA, VIA, VIIA, VIIIA, IB, IIB, IIIB or IVB,
wherein the nitride is a nitride of one or more elements from the Periodic Table of elements shown in Roman numeral column number IIA, IIIA, IVA, VA, VIA, VIIA, VIIIA, IB, IIB, IIIB or IVB, and
wherein the silicide is a silicide of one or more elements from the Periodic Table of elements shown in Roman numeral column number IIA, IIIA, IVA, VA, VIA, VIIA, VIIIA, IB, IIB, IIIB or IVB.

63. The method of Claim 60, wherein the second material has an average particle size between 1 micron and 5 microns.

64. The method of Claim 60, wherein the plurality of materials includes a third material, the third material comprised of platinum (Pt) or tantalum (Ta).

65. The method of Claim 60, wherein the plurality of materials further includes a third material comprised of a transition element powder, a refractory element powder, a cobalt-transition element based master alloy powder, a cobalt-refractory element based master alloy powder, a transition element based compound powder, or a refractory element based compound powder.

66. A method of fabricating a sputter target, the method comprising the steps of:
blending a plurality of materials including at least a first material and a second material, the first material comprised of cobalt (Co), ruthenium (Ru), nickel (Ni), or iron (Fe), the second material comprised of an oxygen (O)-containing material or an oxide, the second material having an average particle size between greater than 0 micron and 50 microns, the plurality of materials comprised of multiple powders, one or more master alloy or compound powders, or a mixture of one or more powders with one or more master alloy or compound powders;
canning; and
pressing.

67. The method of Claim 66, wherein the oxygen (O)-containing material is an oxygen (O)-containing material including one or more elements from the Periodic Table of elements shown in Roman numeral column number IIA, IIIA, IVA, VA, VIA, VIIA, VIIIA, IB, IIB, IIIB or IVB, and
wherein the oxide is an oxide of one or more elements from the Periodic Table of elements shown in Roman numeral column number IIA, IIIA, IVA, VA, VIA, VIIA, VIIIA, IB, IIB, IIIB or IVB.

68. The method of Claim 66, wherein the second material has an average particle size between 1 micron and 5 microns.

69. The method of Claim 66, wherein the plurality of materials further includes a third material comprised of a transition element, a refractory element, a cobalt-transition element based master alloy, a cobalt-refractory element based master alloy, a transition element based compound, or a refractory element based compound.

70. The method of Claim 66, wherein the second material is comprised of the oxide, wherein the oxide is silicon dioxide (SiO₂).

71. The method of Claim 66, wherein the second material is comprised of the oxide, wherein the oxide is titanium oxide (TiO₂).

72. A method of fabricating a sputter target, the method comprising the steps of:
blending a plurality of materials including at least a first material and a second material, the first material comprised of cobalt (Co), chromium (Cr), ruthenium (Ru), nickel (Ni), or iron (Fe), the second material comprised of an oxygen (O)-containing material or an oxide, the second material having an average particle size between greater than 0 micron and 50 microns, the plurality of materials comprised of multiple powders, one or more master alloy or compound powders, or a mixture of one or more powders with one or more master alloy or compound powders,
wherein if the plurality of materials consists of chromium (Cr) and the oxygen (O)-containing material only, the oxygen (O)-containing material is an oxygen (O)-containing material other than simply chromium oxide, and
wherein if the plurality of materials consists of chromium (Cr) and the oxide only, the oxide is an oxide other than simply chromium oxide;
canning; and
pressing.

73. The method of Claim 72, wherein the second material is comprised of the oxide, wherein the oxide is an oxide of silicon (Si), aluminum (Al) or titanium (Ti).

74. The method of Claim 72, wherein the second material has an average particle size less than 2 microns.

75. The method of Claim 72, wherein the first material is comprised of a cobalt (Co) element, a chromium (Cr) element, a ruthenium (Ru) element, a nickel (Ni) element, an iron (Fe) element, a cobalt (Co) based master alloy, a chromium (Cr) based master alloy, a ruthenium (Ru) based master alloy, a nickel (Ni) based master alloy, an iron (Fe) based master alloy, a cobalt (Co) based compound, a chromium (Cr) based compound, a ruthenium (Ru) based compound, a nickel (Ni) based compound, or an iron (Fe) based compound.

76. The method of Claim 72, wherein the plurality of materials includes a third material, the third material comprised of platinum (Pt) or tantalum (Ta).

77. The method of Claim 72, wherein the sputter target is comprised of Co, Cr, Pt and SiO₂.

78. The method of Claim 72, wherein the second material is comprised of the oxide, wherein the oxide is silicon dioxide (SiO₂).

79. The method of Claim 72, wherein the second material is comprised of the oxide, wherein the oxide is titanium oxide (TiO₂).

80. A method of fabricating a sputter target, the method comprising the steps of:
blending a plurality of materials including at least a first material and a second material, the first material comprised of cobalt (Co), chromium (Cr), ruthenium (Ru), nickel (Ni), or iron (Fe), the second material comprised of boron (B), a boron (B)-containing material or a boride, the second material having an average particle size between greater than 0 micron and less than 10 microns, the plurality of materials comprised of multiple powders, one or more master alloy or compound powders, or a mixture of one or more powders with one or more master alloy or compound powders;
canning; and
pressing.

81. The method of Claim 80, the boron (B)-containing material is a boron (B)-containing material including one or more elements from the Periodic Table of elements shown in Roman numeral column number IIA, IIIA, IVA, VA, VIA, VIIA, VIIIA, IB, IIB, IIIB or IVB, and
wherein the boride is a boride of one or more elements from the Periodic Table of elements shown in Roman numeral column number IIA, IIIA, IVA, VA, VIA, VIIA, VIIIA, IB, IIB, IIIB or IVB.

82. The method of Claim 80, wherein the second material is comprised of boron (B).

83. A method of fabricating a sputter target, the method comprising the steps of:
blending a plurality of materials including at least a first material and a second material, the first material comprised of ruthenium (Ru), nickel (Ni), or iron (Fe), the second material comprised of boron (B), a boron (B)-containing material or a boride, the second material having an average particle size between greater than 0 micron and less than 50 microns, the plurality of materials comprised of multiple powders, one or more master alloy or compound powders, or a mixture of one or more powders with one or more master alloy or compound powders;
canning; and
pressing.

84. The method of Claim 83, wherein the boron (B)-containing material is a boron (B)-containing material including one or more elements from the Periodic Table of elements shown in Roman numeral column number IIA, IIIA, IVA, VA, VIA, VIIA, VIIIA, IB, IIB, IIIB or IVB, and
wherein the boride is a boride of one or more elements from the Periodic Table of elements shown in Roman numeral column number IIA, IIIA, IVA, VA, VIA, VIIA, VIIIA, IB, IIB, IIIB or IVB.

85. The method of Claim 83, wherein the plurality of materials further includes a third material comprised of a transition element powder, a refractory element powder, a cobalt-transition element based master alloy powder, a cobalt-refractory element based master alloy powder, a transition element based compound powder, or a refractory element based compound powder.
